# EUROPEAN PATENT APPLICATION

(11) **EP 4 800 411 A1**
(43) Date of publication of application: **02.09.2026**
(21) Application number: 25867148.6
(22) Date of filing: 03.11.2025
(51) Int. Cl.: G01R 31/396, G01R 31/385, G01R 31/392, G01R 31/367, G01R 31/36, H01M 10/48, G01N 25/72, H01M 4/58, H01M 10/42, H01M 4/02

(54) **BATTERY DIAGNOSIS DEVICE AND METHOD THEREFOR**

(30) Priority: 07.11.2024 KR 20240157231; 07.11.2024 KR 20240175320; 24.10.2025 KR 20250155808
(71) Applicant: LG ENERGY SOLUTION, LTD., Seoul 07335 (KR)
(72) Inventor: KIM, Tae Hyeon, Yuseong-gu Daejeon 34122 (KR); KIM, Young Deok, Yuseong-gu Daejeon 34122 (KR); CHOI, Hyun Jun, Yuseong-gu Daejeon 34122 (KR); KIM, Hye Young, Yuseong-gu Daejeon 34122 (KR)
(74) Representative: Goddar, Heinz J.
(86) International application number: PCT/KR2025/017808
(87) International publication number: WO 2026/101150

(57) **Abstract**

A battery diagnosis apparatus according to an embodiment of this document includes a memory configured to store at least one instruction, and at least one processor configured to execute the at least one instruction. The at least one processor is configured to identify a first temperature that is a temperature related to a battery cell at a first state of charge (SOC), identify a second temperature related to the battery cell at a second SOC different from the first SOC, and diagnose a state of the battery cell on the basis of the first temperature and the second temperature.

## Description

### TECHNICAL FIELD

### CROSS-REFERENCE TO RELATED APPLICATION

The present application claims the benefit of the priority of Korean Patent Application Nos. 10-2024-0157231, filed on November 7, 2024, 10-2024-0157320, filed on November 7, 2024, and 10-2025-0155808, filed on October 24, 2025, which are hereby incorporated by reference in their entirety.

### TECHNICAL FIELD

Embodiments disclosed in this document relate to a battery diagnosis apparatus and a method for diagnosing the battery.

### BACKGROUND ART

Recently, research and development of secondary batteries have been actively performed. Here, the secondary batteries, which are chargeable/dischargeable batteries, may include all of conventional nickel (Ni)/cadmium (Cd) batteries, Ni/metal hydride (MH) batteries, etc., and recent lithium-ion batteries. In addition, the secondary batteries are attracting attention as a next-generation energy storage medium as their scope of use are expanded as power sources for electric vehicles.

With the widespread adoption of various electronic devices due to the fourth industrial revolution, the consumption of batteries is increasing rapidly. Batteries are regarded as essential energy sources in various fields such as electric vehicles, portable electronic devices, and renewable energy storage systems. Thus, the importance of battery state diagnosis technologies for improving performance and reliability of the batteries is increasing.

Particularly, with the increasing demand for cost-effective battery cells, technologies for diagnosing a state of the cost-effective battery cells have come to receive attention. This technology may have features that are different from those of state diagnosis technologies for other battery cells. With the development of the diagnostic technologies for the cost-effective battery cells, reliability of batteries may be improved.

### DISCLOSURE OF THE INVENTION

### TECHNICAL PROBLEM

According to embodiments disclosed in this document, a battery diagnosis apparatus that identifies a degree of degradation of a positive electrode made of lithium iron phosphate (LFP) through a change in temperature of a battery cell, and a method for diagnosing the battery are provided.

According to embodiments disclosed in this document, a battery diagnosis apparatus that identifies a degree of degradation of a positive electrode of a battery cell to improve diagnostic performance of the battery cell, and a method for diagnosing the battery are provided.

According to embodiments disclosed in this document, a battery diagnosis apparatus that identifies a degree of degradation of a positive electrode of a battery cell to control a charging and discharging rate according to the degree of degradation, and a method for diagnosing the battery are provided.

According to embodiments disclosed in this document, a battery diagnosis apparatus that controls a charging and discharging rate according to a degree of degradation to improve stability of a battery cell, and a method for diagnosing the battery are provided.

The objects of this document are not limited to the above-described technical problems, and other unmentioned technical problems would be clearly understood by one of ordinary skill in the art from the following description.

### TECHNICAL SOLUTION

A battery diagnosis apparatus according to an embodiment of this document may include: a memory configured to store at least one instruction; and at least one processor configured to execute the at least one instruction.

According to an embodiment, the at least one processor is configured to: identify a first temperature that is a temperature related to a battery cell at a first state of charge (SOC); identify a second temperature related to the battery cell at a second SOC different from the first SOC; and diagnose a state of the battery cell on the basis of the first temperature and the second temperature.

According to an embodiment, the at least one processor may be configured to identify a degree of degradation of a positive electrode included in the battery cell on the basis of a difference between the first temperature and the second temperature.

According to an embodiment, the degree of degradation of the positive electrode may have a positive correlation with the difference between the first temperature and the second temperature.

According to an embodiment, the at least one processor may be configured to identify the degree of degradation of the positive electrode through a loss of active material (LAM) of the positive electrode.

According to an embodiment, the battery cell may include a battery cell comprising lithium iron phosphate (LFP) in an positive electrode.

According to an embodiment, the first SOC may be a first lower state of charge (SOC) that is less than a critical SOC value, and the second SOC may be a second lower SOC that is less than the critical SOC value and is different from the first lower SOC.

According to an embodiment, the first lower SOC may represent an SOC of the battery cell at a time point at which discharging of the battery cell is completed, and the second lower SOC may represent an SOC at which an absolute value of a value obtained by differentiating the temperature related to the battery cell with respect to the SOC within a specified lower SOC range becomes a minimum value.

According to an embodiment, the lower SOC range may include an SOC value at which the battery cell is identified as being in a fully discharged state.

According to an embodiment, the first SOC may be a first upper state of charge (SOC) that is equal to or higher than a critical SOC value, and the second SOC may be a second lower SOC that is equal to or higher than the critical SOC value and is different from the first upper SOC.

According to an embodiment, the first upper SOC may represent an OSC of the battery cell at a time point at which discharging of the battery cell starts, and the second upper SOC may represent an SOC at which the temperature related to the battery cell within a specified upper SOC range becomes a maximum value.

According to an embodiment, the upper SOC range may include an SOC value at which the battery cell is identified as being in a fully charged state.

A method for diagnosing a battery according to another embodiment of this document may include: identifying a first temperature that is a temperature related to a battery cell at a first state of charge (SOC); identifying a second temperature related to the battery cell at a second SOC different from the first SOC; and diagnosing a state of the battery cell on the basis of the first temperature and the second temperature.

According to an embodiment, the diagnosing of the state of the battery cell on the basis of the first temperature and the second temperature may include identifying a degree of degradation of a positive electrode comprised in the battery cell on the basis of a difference between the first temperature and the second temperature.

According to an embodiment, the degree of degradation of the positive electrode may have a positive correlation with the difference between the first temperature and the second temperature.

According to an embodiment, the identifying of the degree of degradation of the positive electrode included in the battery cell on the basis of the difference between the first temperature and the second temperature may include identifying the degree of degradation of the positive electrode through a loss of active material (LAM) of the positive electrode.

According to an embodiment, the battery cell comprises a battery cell may include lithium iron phosphate (LFP) in an positive electrode. The battery cell may be provided.

According to an embodiment, the first SOC may be a first lower state of charge (SOC) that is less than a critical SOC value, and the second SOC may be a second lower SOC that is less than the critical SOC value and is different from the first lower SOC.

According to an embodiment, the first lower SOC may represent an SOC of the battery cell at a time point at which discharging of the battery cell is completed, and the second lower SOC may represent an SOC at which an absolute value of a value obtained by differentiating the temperature related to the battery cell with respect to the SOC within a specified lower SOC range becomes a minimum value.

According to an embodiment, the lower SOC range may include an SOC value at which the battery cell is identified as being in a fully discharged state.

According to an embodiment, the first SOC may be a first upper state of charge (SOC) that is equal to or higher than a critical SOC value, and the second SOC may be a second lower SOC that is equal to or higher than the critical SOC value and is different from the first upper SOC.

According to an embodiment, the first upper SOC may represent an OSC of the battery cell at a time point at which discharging of the battery cell starts, and the second upper SOC may represent an SOC at which the temperature related to the battery cell within a specified upper SOC range becomes a maximum value.

According to an embodiment, the upper SOC range may include an SOC value at which the battery cell is identified as being in a fully charged state.

### ADVANTAGEOUS EFFECTS

In this technology, the degree of degradation of the positive electrode made of lithium iron phosphate (LFP) may be identified through the change in temperature of the battery cell.

In addition, in this technology, the degree of degradation of the positive electrode of the battery cell may be identified to improve the diagnostic performance of the battery cell.

In addition, in this technology, the degree of degradation of the positive electrode of the battery cell may be identified to control the charging and discharging rate according to the degree of degradation.

In addition, in this technology, the charging and discharging rate according to the degree of degradation may be controlled to improve the stability of the battery cell.

Moreover, the various effects recognized directly or indirectly from the disclosure may be provided.

### BRIEF DESCRIPTION OF THE DRAWINGS

FIG. 1 is a block diagram illustrating a battery pack in a battery diagnosis apparatus and a method for diagnosing a battery according to an embodiment of this document.
FIG. 2 is a block diagram illustrating a configuration of the battery diagnosis apparatus in the battery diagnosis apparatus and the method for diagnosing the battery according to an embodiment of this document.
FIG. 3 is a view illustrating an example of a graph showing a temperature depending on a capacity of a battery cell in the battery diagnosis apparatus and the method for diagnosing the battery according to an embodiment of this document.
FIG. 4 is a view illustrating an example of a graph showing a temperature depending on a degree of degradation in the battery diagnosis apparatus and the method for diagnosing the battery according to an embodiment of this document.
FIG. 5 is a view illustrating an example of a graph showing a temperature depending on a capacity of a first cell in the battery diagnosis apparatus and the method for diagnosing the battery according to an embodiment of this document.
FIG. 6 is a view illustrating an example of a graph showing a temperature depending on a capacity of a second cell in the battery diagnosis apparatus and the method for diagnosing the battery according to an embodiment of this document.
FIG. 7 is a view illustrating a flow of an operation of the battery diagnosis apparatus that diagnoses a state of the battery cell on the basis of a temperature of a battery cell having an upper SOC in the battery diagnosis apparatus and the method for diagnosing the battery according to an embodiment of this document.
FIG. 8 is a view illustrating a flow of an operation of the battery diagnosis apparatus that diagnoses a state of the battery cell on the basis of a temperature of a battery cell having a lower SOC in the battery diagnosis apparatus and the method for diagnosing the battery according to an embodiment of this document.
FIG. 9 is a block diagram illustrating a hardware configuration of a computing system for performing the method for diagnosing the battery in the battery diagnosis apparatus and the method for diagnosing the battery according to an embodiment of this document.

### MODE FOR CARRYING OUT THE INVENTION

Hereinafter, some embodiments disclosed in this document will be described with reference to the accompanying drawings, which illustrate various embodiments of this document. However, this is not intended to limit this technology to specific embodiments, but should be understood to include various modifications, equivalents, and/or alternatives of the embodiments of this technology.

It is noted that the same or similar components in the drawings are designated by the same reference numerals as far as possible even if they are illustrated in different drawings. In the various embodiments disclosed in this document, a detailed description of known functions and configurations incorporated herein will be omitted to avoid making the subject matter of the present invention unclear. The singular form of a noun corresponding to an item may include one or more of the items, unless the context clearly indicates otherwise.

In description of components of an embodiment of this document, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

In addition, in the present disclosure, expressions such as "exceed" or "fall below" may be used to determine whether a specific condition is satisfied or fulfilled, but this is merely an example for illustration, and does not exclude the use of expressions such as "at least" or "at most". The condition stated as "or more" may be replaced with "or less", the condition stated as "or less" may be replaced with "or more", and the condition stated as "or more and/or or less" may be replaced with "or more and/or or less". In addition, hereinafter, "A" to "B" refer to at least one of elements from A (inclusive) to B (inclusive).

In this document, each of the phrases "A or B", "at least one of A and B", "at least one of A or B", "A, B, or C", "at least one of A, B, and C", and "at least one of A, B, or C" may include any one of the items listed together in that phrase, or all possible combinations of them.

In this document, when a component (e.g., a first component) is referred to as being "linked," "coupled," or "connected," or "coupled" to another component (e.g., a second component), with or without the terms "functionally" or "communicatively," it means that the component can be connected to the other component directly (e.g., wired or wirelessly), or through a third component.

According to an embodiment, a method according to various embodiments disclosed in this document may be provided as included in a computer program product. The computer program product may be traded between sellers and buyers as commodities. The computer program product may be distributed in the form of a machine-readable storage medium (e.g., compact disc read only memory(CD-ROM))), or may be distributed (e.g., downloaded or uploaded) on-line through an application store or directly between two user devices. In the case of the on-line distribution, at least a portion of the computer program product may be temporarily stored or temporarily created in the machine-readable storage medium such as a memory of a manufacturer's server, an application store's server, or an intermediary server.

According to various embodiments disclosed in this document, each component (e.g., a module or a program) of the components described above may include a single or multiple unities, and some of the multiple units may be separated and placed in other components. According to various embodiments, one or more of the above-described corresponding components or operations may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by the module, the program, or other component may be performed sequentially, in parallel, iteratively, or heuristically, or one or more of the operations may be performed in a different order or omitted, or one or more other operations may be added.

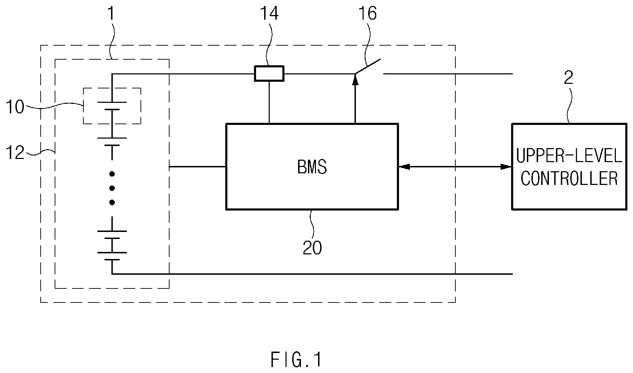

Hereinafter, embodiments of this document will be described in detail with reference to FIGS. 1 to 9.

FIG. 1 is a block diagram illustrating a battery pack in a battery diagnosis apparatus and a method for diagnosing a battery according to an embodiment of this document.

Referring to FIG. 1, a battery pack 1 may include a battery unit 12, a sensor unit 14, a switching unit 16, and a battery management system (BMS) 20. Here, the battery pack 1 may include a plurality of battery units 12, sensors 14, switching units 16, and battery management systems 20.

According to an embodiment, the battery unit 12 may supply power to a target device (not shown). For this, the battery unit 12 may be electrically connected to the target device. Here, the target device may include an electrical, electronic, or mechanical device that operates by receiving the power from the battery pack 1. For example, the target device may be an electric vehicle (EV) or an energy storage system (ESS), but is not limited thereto.

According to an embodiment, the battery unit 12 may include at least one battery cell 10 capable of being charged and discharged. Here, the battery cell 10 may be a radial unit of the battery cell capable of charging and discharging electrical energy. For example, the battery cell 10 may include a lithium ion (Li-ion) battery, a lithium ion polymer battery, a nickel cadmium (Ni-Cd) battery, a nickel metal hydride (Ni-MH) battery, etc., but is not limited thereto.

According to an embodiment, the plurality of battery units 12 may be connected in series or in parallel. For example, the battery unit 12 may be a battery module, a battery bank, or an assembly (cell-to-pack structure) of battery cells.

According to an embodiment, the sensor unit 14 may acquire information related to the battery unit 12. According to an embodiment, the sensor unit 14 may acquire values (or information) related to a state of each of the battery cells 10 or the battery unit 12. In an embodiment, values related to the state may include at least one value for a voltage, current, resistance, a state of charge (SOC), a state of health (SOH) of the battery cell, a temperature, or a combination thereof.

According to an embodiment, the sensor unit 14 may provide information on each of the plurality of battery units 12 to the battery management system 20.

According to an embodiment, the switching unit 16 may include elements for controlling a current flow for charging or discharging of the battery unit 12. For example, the switching unit 16 may include at least one relay and/or magnetic contactor, etc., depending on specifications of the battery pack 1.

According to an embodiment, the battery management system (BMS) 20 may monitor a voltage, current, a temperature, etc., of the battery pack 1 to control or manage the battery pack 1 so as to prevent overcharging and overdischarging. For example, the battery management system 20, which is an interface for receiving measurement values of the above-described various parameter values, may include a plurality of terminals and a circuit, etc., which is connected to the terminals to process input values. In addition, the battery management system 20 may control the sensor unit 14 and/or the switching unit 16. For example, the battery management system 20 may be connected to the plurality of battery units 12 to monitor the state of each of the plurality of battery units 12 and may also control the ON/OFF of the relay or the contactor.

According to an embodiment, the operation of the battery management system 20 may be performed by the battery management system (BMS) in a vehicle or may also be performed by various devices such as a server, a cloud, a charger, or a discharger.

An upper-level controller 2 may transmit control signals for the plurality of battery units 12 to the battery management system 20. Thus, the operation of the battery management system 20 may also be controlled on the basis of the signals applied from the upper-level controller 2.

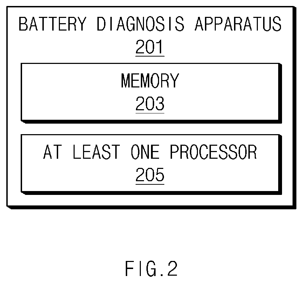

According to an embodiment, the battery management system 20 may include a battery diagnosis apparatus 201 of FIG. 2. According to another embodiment, the battery management system 20 may be different from the battery diagnosis apparatus 201 of FIG. 2. That is, the battery diagnosis apparatus 201 of FIG. 2 may be included in the battery pack 1 and may be configured as another device outside the battery pack 1. Hereinafter, for convenience of description, it is assumed that the battery diagnosis apparatus 201 is configured as another device outside the battery pack 1. In addition, the operation of the battery diagnosis apparatus 201 described below may be performed by the battery management system (BMS) within the vehicle, as well as by the various devices such as the server, the cloud, the charger, or the discharger.

FIG. 2 is a block diagram illustrating a configuration of the battery diagnosis apparatus in the battery diagnosis apparatus and the method for diagnosing the battery according to an embodiment of this document.

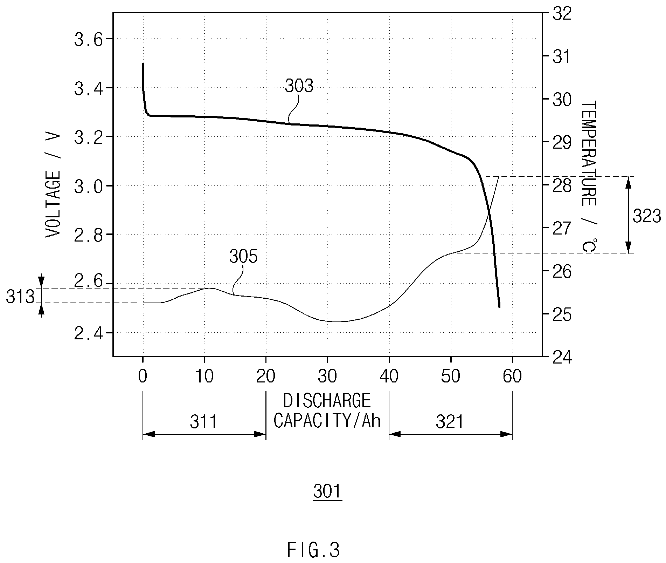

FIG. 3 is a view illustrating an example of a graph showing a temperature depending on a capacity of a battery cell in the battery diagnosis apparatus and the method for diagnosing the battery according to an embodiment of this document.

Referring to FIGS. 2 and 3, the battery diagnosis apparatus 201 may include a memory 203 and at least one processor 205. The memory 203 may store at least one instruction. The at least one processor 205 may execute the at least one instruction.

A graph 301 may represent a change in measured value of a battery cell depending on a discharge capacity of the battery cell. A first line 303 may represent a voltage of the battery cell depending on a discharge capacity. A second line 305 may represent a temperature of the battery cell depending on a discharge capacity. A first range 311 may be referred to as an upper state of charge (SOC) range. The first range 311 may include an SOC value of the battery cell at a time point when the discharging of the battery cell starts. A second range 321 may be referred to as a lower SOC range. The second range 321 may include an SOC value of the battery cell at a time point when the discharging of the battery cell is completed. A first temperature difference 313 may represent a difference between a temperature of the battery cell at the first upper SOC and a temperature of the battery cell at the second upper SOC. A second temperature difference 323 may represent a difference between a temperature of the battery cell at a first lower SOC and a temperature of the battery cell at a second lower SOC.

Hereinafter, although the temperature related to the battery cell is described as a temperature of the battery cell, an embodiment of this document is not limited thereto. This is because the temperature is not measured in a unit of the battery cell, but rather in a unit of a battery unit (e.g., battery module, battery pack, battery). Thus, according to an embodiment, the temperature related to a battery cell may be understood as the temperature of the battery unit, which is a unit in which the temperature of the battery cell for which the temperature is being measured is included.

According to an embodiment, at least one processor of the battery diagnosis apparatus may measure a degree of degradation of the battery cell through a graph representing a voltage depending on the SOC of the battery cell.

However, in the case of the battery cell including lithium iron phosphate (LFP) as a positive electrode material, it may be difficult to measure the degree of degradation of the battery cell through the graph representing the voltage depending on the state of charge (SOC) of the battery cell.

For example, in the case of a battery cell containing a positive electrode material other than LFP, since the graph representing the voltage depending on the SOC generally has a constant inclination, a line obtained by differentiating the voltage with respect to the SOC may exhibit a characteristic peak depending on the degree of degradation of the positive electrode. However, in the case of the battery cell including an LFP as the positive electrode material, the line obtained by differentiating the voltage with respect to the SOC may not show the characteristic peak, and thus, it is not possible to measure the degree of degradation of the positive electrode of the battery cell.

Thus, the at least one processor 205 of the battery diagnosis apparatus 201 may identify the degree of degradation of the positive electrode of the battery cell on the basis of the graph representing the temperature depending on the SOC, rather than the graph representing the voltage depending on the SOC. This is because the graph representing the temperature depending on the SOC of the battery cell varies depending on the degree of degradation of the positive electrode.

According to an embodiment, the at least one processor 205 of the battery diagnosis apparatus 201 may identify a temperature of the battery cell while discharging the battery cell.

According to an embodiment, the at least one processor 205 of the battery diagnosis apparatus 201 may identify a first temperature including the temperature of the battery cell at the first upper SOC that is equal to or higher than a critical SOC value (e.g., about 50%). The first upper SOC may be included in the first range 311. The first upper SOC may represent the SOC of the battery cell at the time point when the discharging of the battery cell starts.

According to an embodiment, the at least one processor 205 of the battery diagnosis apparatus 201 may identify a second temperature including a temperature of the battery cell at the second upper SOC that is equal to or higher than the critical SOC value. The second upper SOC may represent an SOC at which the temperature of the battery cell becomes a maximum value within the upper SOC range (e.g., first range 311).

The upper SOC range (e.g., first range 311) may include an SOC value at which the battery cell is identified as being in a fully charged state. Since an X-axis of the graph 301 represents a discharge capacity, the SOC of the battery cell in the first range 311 may be higher than the SOC of the battery cell in the second range 321.

According to an embodiment, the degree of degradation of the positive electrode included in the battery cell may be identified on the basis of a difference between the first temperature and the second temperature (e.g., the first temperature difference 313). In the case of the battery cell including the LFP as the positive electrode material, there is a positive correlation between the degree of degradation of the positive electrode and the difference between the first temperature and the second temperature (e.g., the first temperature difference 313).

According to an embodiment, the at least one processor 205 of the battery diagnosis apparatus 201 may identify a third temperature including the temperature of the battery cell at the first lower SOC that is less than the critical SOC value (e.g., about 50%). The first lower SOC may be included in the second range 321. The first lower SOC may represent an SOC of the battery cell at a time point when the discharging of the battery cell is completed.

According to an embodiment, the at least one processor 205 of the battery diagnosis apparatus 201 may identify a fourth temperature including the temperature of the battery cell at the second lower SOC that is less than the critical SOC value. The second upper SOC may represent an SOC at which an absolute value of the value obtained by differentiating the temperature of the battery cell with respect to the SOC in the lower SOC range (e.g., the second range 321) becomes the smallest.

The lower SOC range (e.g., second range 321) may include an SOC value at which the battery cell is identified as being in a fully discharged state.

According to an embodiment, the degree of degradation of the positive electrode included in the battery cell may be identified on the basis of a difference between the third temperature and the fourth temperature (e.g., the second temperature difference 323). In the case of the battery cell including the LFP as the positive electrode material, there is a positive correlation between the degree of degradation of the positive electrode and the difference between the third temperature and the fourth temperature (e.g., the second temperature difference 323).

The degree of degradation of the positive electrode may include a loss of active material (LAM) of the positive electrode.

According to an embodiment, a negative electrode material of the battery cell from which the graph 301 is obtained may be graphite, and the positive electrode material may be LFP. Current of the battery cell may be about 0.33 C (charge-rate).

The change in temperature of the battery cell may occur due to a change in entropy of the negative electrode material or positive electrode material and may be related to resistance and current intensity of the battery cell. In the upper SOC range, a stagging reaction, which is a phase change of the negative electrode, is completed, and a temperature change may occur due to the LFP, which is the positive electrode material. Even in the lower SOC range, the stagging reaction of the negative electrode may be completed, and the temperature change may occur due to the LFP, which is the positive electrode material.

Thus, the at least one processor 205 of the battery diagnostic device 201 may diagnose the state of an LFP through the change in temperature of the battery cell in the upper SOC range and the lower SOC range in which the stagging reaction of the negative electrode occurs below a reference value.

When it is confirmed that the degree of degradation of the positive electrode is equal to or higher than a reference degree, the at least one processor 205 of the battery diagnosis apparatus 201 may reduce the charging or discharging rate to be less than the reference rate, thereby alleviating uneven degradation occurring inside the battery cell.

According to an embodiment, the at least one processor of the battery diagnosis apparatus 201 may identify a first temperature that is a temperature related to the battery cell at the first state of charge (SOC), may identify a second temperature that is a temperature related to the battery cell at the second SOC different from the first SOC, and may diagnose a state of the battery cell on the basis of the first temperature and the second temperature.

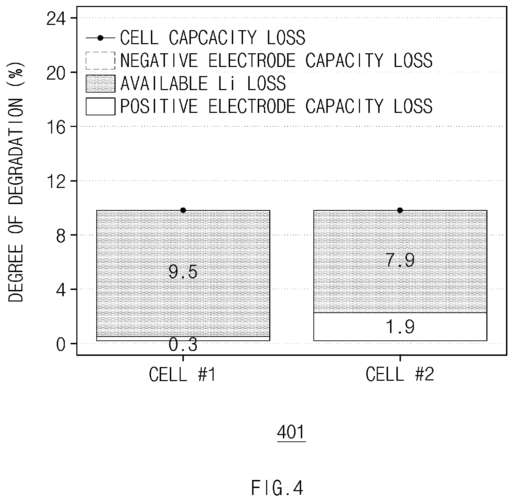

FIG. 4 is a view illustrating an example of a graph showing the temperature depending on the degree of degradation in the battery diagnosis apparatus and the method for diagnosing the battery according to an embodiment of this document.

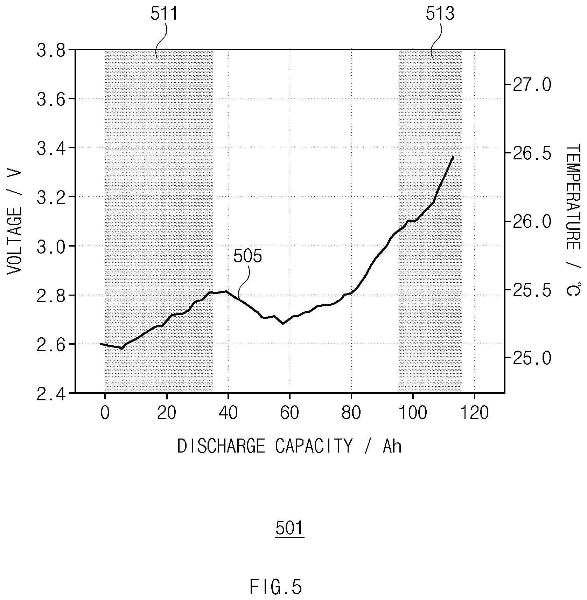

FIG. 5 is a view illustrating an example of a graph showing the temperature depending on the capacity of a first cell in the battery diagnosis apparatus and the method for diagnosing the battery according to an embodiment of this document.

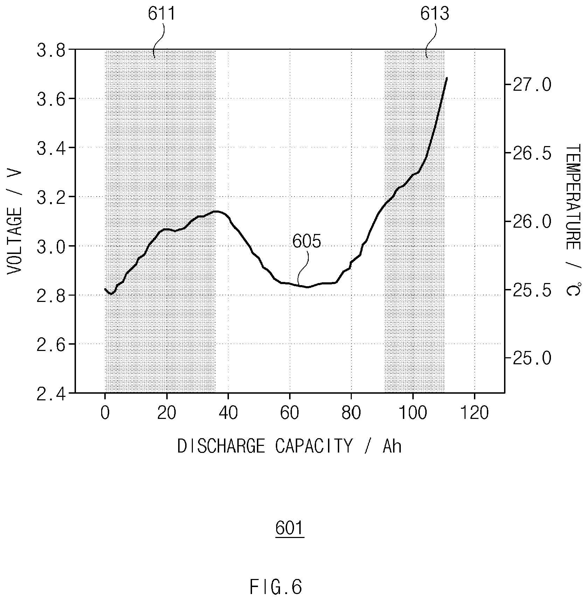

FIG. 6 is a view illustrating an example of a graph showing the temperature depending on the capacity of a second cell in the battery diagnosis apparatus and the method for diagnosing the battery according to an embodiment of this document.

Referring to FIGS. 4, 5, and 6, a graph 401 may represent a degree of degradation of a first cell and a second cell. As shown in graph 401, the degree of degradation of the first cell may be about 9.8%, and the degree of degradation of the second cell may also be about 9.8%.

A graph 501 may represent a change in measured value of the battery cell depending on a discharge capacity of the first cell. A first line 505 may represent the temperature of the first cell depending on the discharge capacity. A first upper range 511 may be referred to as the upper state of charge (SOC) range. A first lower range 513 may be referred to as a lower SOC range.

A graph 601 may represent a change in measured value of the battery cell depending on a discharge capacity of the second cell. A second line 605 may represent the temperature of the second cell depending on the discharge capacity. The second upper range 611 may be referred to as an upper state of charge (SOC) range. A second lower range 621 may be referred to as a lower SOC range.

According to the graph 401, although the degrees of degradation of the first cell and the second cell are the same, ratios of the degree of degradation due to an available lithium loss to the degree of degradation due to a positive electrode capacity loss may be different. For example, the degree of degradation due to the available lithium loss in the first cell may be about 9.5%, and the degree of degradation due to the positive electrode capacity loss in the first cell may be about 0.3%. For example, the degree of degradation due to the available lithium loss in the second cell may be about 7.9%, and the degree of degradation due to the positive electrode capacity loss in the second cell may be about 1.9%.

The at least one processor 205 of the battery diagnosis apparatus 201 may identify the degree of the positive electrode capacity loss of the first cell and the degree of the positive electrode capacity loss of the second cell through the temperature change depending on the SOC of the first cell and the second cell. The degree of the positive electrode capacity loss may indicate the degree of degradation of the positive electrode.

According to an embodiment, the at least one processor 205 of the battery diagnosis apparatus 201 may identify the degree of degradation of the positive electrode of the first cell on the basis of a difference between the first temperature of the first cell at the first upper SOC and the second temperature of the second cell at the second upper SOC in the upper SOC range (e.g., first upper range 511) of the first cell of the first line 505 in the graph 501. In the upper SOC range of the first cell of the first line 505, the difference between the first temperature and the second temperature may be about 0.41°C.

According to an embodiment, at the upper SOC range (e.g., second upper range 611) of the second cell of the second line 605 in the graph 601, the degree of degradation of the positive electrode of the second cell may be identified on the basis of the difference between the third temperature of the second cell at the third upper SOC and the fourth temperature of the second cell at the fourth upper SOC. In the upper SOC range of the second cell of the second line 605, the difference between the third temperature and the fourth temperature may be about 0.61°C.

In the upper SOC range, the at least one processor 205 of the battery diagnosis apparatus 201 may identify that the degree of degradation of the positive electrode of the second cell is greater than the degree of degradation of the positive electrode of the first cell because the temperature difference (e.g., about 0.61°C) of the second cell is greater than the temperature difference (e.g., about 0.41°C) of the first cell.

Thus, it may be confirmed that there is a strong correlation between the degree of degradation of a battery cell and the temperature difference at the upper SOC range of the battery cell. This may be because the overall degrees of degradation of the first cell and the second cell are the same, but the temperature differences are different. Particularly, when the degree of degradation of the positive electrode increases, resistance of the positive electrode increases, and when the resistance of the positive electrode increases, the temperature increases. For example, since the positive electrode of the second cell has degraded more than the positive electrode of the first cell, resistance of the second cell may be greater than resistance of the first cell. Thus, even if current is supplied to the first cell and the second cell with the same current density, the temperature difference in the upper SOC range of the second cell may be greater than the temperature difference in the upper SOC range of the first cell.

According to an embodiment, the at least one processor 205 of the battery diagnosis apparatus 201 may identify the degree of degradation of the positive electrode of the first cell on the basis of a difference between a fifth temperature of the first cell at the first lower SOC and a sixth temperature of the first cell at the second lower SOC in the lower SOC range (e.g., the first lower range 513) of the first cell of the first line 505 in the graph 501. In the lower SOC range of the first cell of the first line 505, the difference between the fifth temperature and the sixth temperature may be about 0.46°C.

According to an embodiment, the at least one processor 205 of the battery diagnosis apparatus 201 may identify the degree of degradation of the positive electrode of the second cell on the basis of a difference between a seventh temperature of the second cell at the third lower SOC and an eighth temperature of the second cell at the fourth lower SOC in the lower SOC range (e.g., the second lower range 613) of the second cell of the second line 605 in the graph 601. In the lower SOC range of the second cell of the second line 605, the difference between the seventh temperature and the eighth temperature may be about 0.8°C.

In the lower SOC range, the at least one processor 205 of the battery diagnosis apparatus 201 may identify that the degree of degradation of the positive electrode of the second cell is greater than the degree of degradation of the positive electrode of the first cell because the temperature difference (e.g., about 0.8°C) of the second cell is greater than the temperature difference (e.g., about 0.46°C) of the first cell.

Like the upper SOC range, it may be confirmed that there is a strong correlation between the degree of degradation of the battery cell and the temperature difference in the lower SOC range of the battery cell. This may be because the overall degrees of degradation of the first cell and the second cell are the same, but the temperature differences are different. Particularly, like the upper SOC range, since the positive electrode of the second cell has degraded more than the positive electrode of the first cell, resistance of the second cell may be greater than resistance of the first cell. Thus, even if current is supplied to the first cell and the second cell with the same current density, the temperature difference in the lower SOC range of the second cell may be greater than the temperature difference in the lower SOC range of the first cell.

A method for measuring the temperature measured in FIGS. 4 and 5 may involve a method for pressing and fastening the pouch-type first cell or second cell with a metal plate to attach a temperature measuring instrument to the plate. However, an embodiment of this document is not limited thereto. The higher accuracy of the method for measuring the temperature of the battery cell, the higher accuracy of the method for measuring the degree of degradation of the positive electrode through the temperature difference.

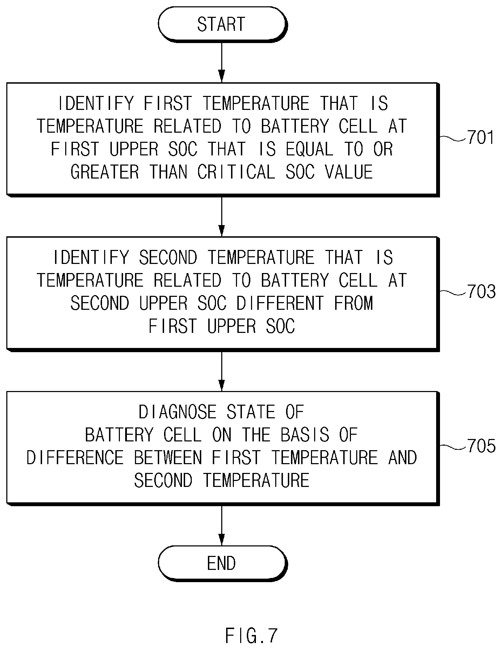

FIG. 7 is a view illustrating a flow of an operation of the battery diagnosis apparatus that diagnoses the state of the battery cell on the basis of the temperature of the battery cell having the upper SOC in the battery diagnosis apparatus and the method for diagnosing the battery according to an embodiment of this document.

Hereinafter, it is assumed that at least one processor 205 included in the battery diagnosis apparatus 201 of FIG. 2 performs the process of FIG. 7. In addition, in the description of FIG. 7, an operations described as being performed by the battery diagnosis apparatus 201 may be understood as being controlled by at least one processor 205 included in the battery diagnosis apparatus 201.

Referring to FIG. 7, in first operation 701, the at least one processor 205 of the battery diagnosis apparatus 201 according to an embodiment may identify a first temperature that is a temperature related to the battery cell at the first upper state of charge (SOC) that is equal to or higher than the critical SOC value.

According to an embodiment, the temperature related to the battery cell may be understood as the temperature of the battery cell or the temperature of the battery unit, which includes the battery cell in which the temperature is measured. According to an embodiment, the first upper SOC may represent the SOC of the battery cell at the time point at which the discharging of the battery cell starts.

In second operation 703, the at least one processor 205 of the battery diagnosis apparatus 201 according to an embodiment may identify a second temperature that is a temperature related to the battery cell at the second upper SOC that is different from the first upper SOC.

According to an embodiment, the second upper SOC may represent an SOC at which the temperature of the battery cell or the temperature of the battery becomes a maximum value within a specified upper SOC range.

In third operation 705, the at least one processor 205 of the battery diagnosis apparatus 201 according to an embodiment may diagnose the state of the battery cell on the basis of the first temperature and the second temperature.

According to an embodiment, the at least one processor 205 of the battery diagnosis apparatus 201 may identify a degree of degradation of the positive electrode of the battery cell having a positive correlation with a difference between the first temperature and the second temperature on the basis of the difference between the first temperature and the second temperature.

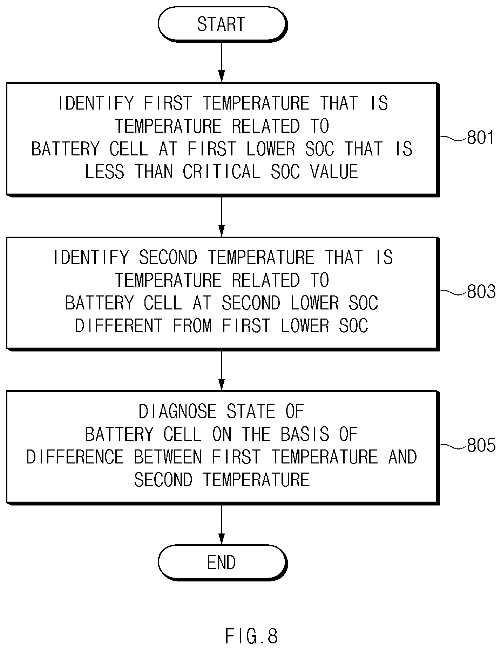

FIG. 8 is a view illustrating a flow of an operation of the battery diagnosis apparatus that diagnoses a state of the battery cell on the basis of a temperature of the battery cell having the lower SOC in the battery diagnosis apparatus and the method for diagnosing the battery according to an embodiment of this document.

Hereinafter, it is assumed that at least one processor 205 included in the battery diagnosis apparatus 201 of FIG. 2 performs the process of FIG. 8. In addition, in the description of FIG. 8, an operations described as being performed by the battery diagnosis apparatus 201 may be understood as being controlled by at least one processor 205 included in the battery diagnosis apparatus 201.

In first operation 801, the at least one processor 205 of the battery diagnostic device 201 according to an embodiment may identify a first temperature that is a temperature related to a battery cell at the first lower SOC that is less than the critical SOC value.

According to an embodiment, the temperature related to the battery cell may be understood as the temperature of the battery cell or the temperature of the battery unit, which includes the battery cell in which the temperature is measured.

According to an embodiment, the first lower SOC may represent an SOC of the battery cell at a time point when the discharging of the battery cell is completed.

In second operation 803, the at least one processor 205 of the battery diagnosis apparatus 201 according to an embodiment may identify a second temperature that is a temperature related to the battery cell in the second lower SOC different from the first lower SOC.

According to an embodiment, the second lower SOC may represent an SOC at which an absolute value of a value obtained by differentiating the temperature of the battery cell or the temperature of the battery with respect to the SOC becomes the smallest value within a specified lower SOC range.

In third operation 805, the at least one processor 205 of the battery diagnosis apparatus 201 according to an embodiment may diagnose the state of the battery cell on the basis of the first temperature and the second temperature.

According to an embodiment, the at least one processor 205 of the battery diagnosis apparatus 201 may identify a degree of degradation of the positive electrode of the battery cell having a positive correlation with a difference between the first temperature and the second temperature on the basis of the difference between the first temperature and the second temperature.

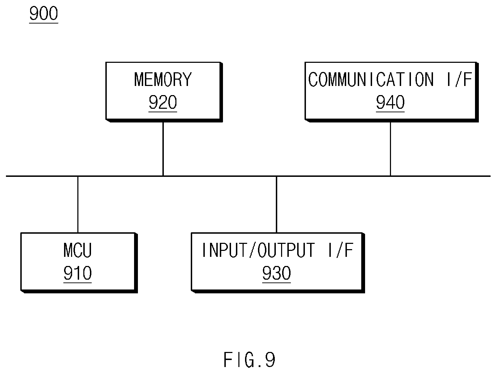

FIG. 9 is a block diagram illustrating a hardware configuration of a computing system for performing the method for diagnosing the battery in the battery diagnosis apparatus and the method for diagnosing the battery according to an embodiment of this document.

Referring to FIG. 9, a computing system 900 according to an embodiment disclosed in the this document may include an MCU 910, a memory 920, an input/output I/F 930, and a communication I/F 940.

The MCU 910 may be one or more processors configured to execute various programs (e.g., a battery cell data collection program, a graph calculation program, a data analysis program, a data decomposition algorithm, a normalization program, and a battery cell diagnosis program) stored in the memory 920, process various pieces of information including characteristic data and latent variables of the battery cells through these programs, and perform the functions of the battery diagnosis apparatus 201 illustrated in FIGS. 2 to 8.

The memory 920 may store the various programs such as the battery cell data collection program, the graph calculation program, the data analysis program, the data decomposition algorithm, the normalization program, and the battery cell diagnosis program.

The memory 920 may be provided in plural, depending on a need. The memory 920 may be volatile memory or nonvolatile memory. For the memory 920 as the volatile memory, random access memory (RAM), dynamic RAM (DRAM), static RAM (SRAM), etc., may be used. For the memory 920 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 920 are merely examples and are not limited thereto.

The input/output I/F 930 may provide an interface for transmitting and receiving data by connecting an input device (not shown) such as a keyboard, a mouse, a touch panel, etc., and an output device such as a display (not shown), etc., to the MCU 910.

The communication I/F 940, which is a component capable of transmitting and receiving various data to and from a server, may be various devices capable of supporting wired or wireless communication. For example, the battery diagnosis apparatus 201 may transmit/receive various pieces of information, including a shape model of the battery cell, from an externally provided server through the communication I/F 940.

As such, a computer program according to an embodiment disclosed herein may be recorded in the memory 920 and processed by the MCU 910, thus being implemented as a module that performs functions shown in FIG. 2.

In the above, it is described that all components constituting the embodiment disclosed in this document are combined or operated in combination as one, but the embodiments disclosed in this document are not necessarily limited to such embodiments. That is, within the scope of the purpose of the embodiments disclosed in this document, all of the components may be selectively combined and operated one or more times.

In addition, the terms "include," "comprise," or "have," etc., as described above, unless otherwise specifically stated, imply that the corresponding component may be included, and therefore should be interpreted as including other components rather than excluding other components. All terms, including technical or scientific terms, unless otherwise defined, have the same meaning as commonly understood by one of ordinary skill in the art to which the embodiments disclosed herein belong. Terms such as terms that are generally used and have been in the dictionary should be interpreted as having meanings matched with contextual meanings in the art. In this document, unless defined clearly, terms are not ideally, excessively construed as formal meanings.

The above-described disclosure provides a brief description of certain features of some embodiments so that those skilled in the art may better understand the aspects of this disclosure. Those skilled in the art will understand that the present disclosure can be readily used as a basis for designing or modifying other structures to perform the same function or achieve the same advantages as the embodiments incorporated herein. Furthermore, those skilled in the art will recognize that such equivalent configurations do not depart from the scope of the present disclosure, and that various changes, substitutions, and modifications can be made herein without departing from the scope of the present disclosure.

## Claims

1. A battery diagnosis apparatus comprising:
a memory configured to store at least one instruction; and
at least one processor configured to execute the at least one instruction,
wherein the at least one processor is configured to:
identify a first temperature that is a temperature related to a battery cell at a first state of charge (SOC);
identify a second temperature related to the battery cell at a second SOC different from the first SOC; and
diagnose a state of the battery cell on the basis of the first temperature and the second temperature.

2. The battery diagnosis apparatus of claim 1, wherein the at least one processor is configured to identify a degree of degradation of a positive electrode comprised in the battery cell on the basis of a difference between the first temperature and the second temperature.

3. The battery diagnosis apparatus of claim 2, wherein the degree of degradation of the positive electrode has a positive correlation with the difference between the first temperature and the second temperature.

4. The battery diagnosis apparatus of claim 2, wherein the at least one processor is configured to identify the degree of degradation of the positive electrode through a loss of active material (LAM) of the positive electrode.

5. The battery diagnosis apparatus of claim 1, wherein the battery cell comprises a battery cell comprising lithium iron phosphate (LFP) in an positive electrode.

6. The battery diagnosis apparatus of claim 1, wherein the first SOC is a first lower state of charge (SOC) that is less than a critical SOC value, and
the second SOC is a second lower SOC that is less than the critical SOC value and is different from the first lower SOC.

7. The battery diagnosis apparatus of claim 6, wherein the first lower SOC represents an SOC of the battery cell at a time point at which discharging of the battery cell is completed, and
the second lower SOC represents an SOC at which an absolute value of a value obtained by differentiating the temperature related to the battery cell with respect to the SOC within a specified lower SOC range becomes a minimum value.

8. The battery diagnosis apparatus of claim 7, wherein the lower SOC range comprises an SOC value at which the battery cell is identified as being in a fully discharged state.

9. The battery diagnosis apparatus of claim 1, wherein the first SOC is a first upper state of charge (SOC) that is equal to or higher than a critical SOC value, and
the second SOC is a second lower SOC that is equal to or higher than the critical SOC value and is different from the first upper SOC.

10. The battery diagnosis apparatus of claim 9, wherein the first upper SOC represents an OSC of the battery cell at a time point at which discharging of the battery cell starts, and
the second upper SOC represents an SOC at which the temperature related to the battery cell within a specified upper SOC range becomes a maximum value.

11. The battery diagnosis apparatus of claim 10, wherein the upper SOC range comprises an SOC value at which the battery cell is identified as being in a fully charged state.

12. A method for diagnosing a battery, the method comprising:
identifying a first temperature that is a temperature related to a battery cell at a first state of charge (SOC);
identifying a second temperature related to the battery cell at a second SOC different from the first SOC; and
diagnosing a state of the battery cell on the basis of the first temperature and the second temperature.

13. The method of claim 12, wherein the diagnosing of the state of the battery cell on the basis of the first temperature and the second temperature comprises identifying a degree of degradation of a positive electrode comprised in the battery cell on the basis of a difference between the first temperature and the second temperature.

14. The method of claim 13, wherein the degree of degradation of the positive electrode has a positive correlation with the difference between the first temperature and the second temperature.

15. The method of claim 13, wherein the identifying of the degree of degradation of the positive electrode comprised in the battery cell on the basis of the difference between the first temperature and the second temperature comprises identifying the degree of degradation of the positive electrode through a loss of active material (LAM) of the positive electrode.

16. The method of claim 12, wherein the battery cell comprises a battery cell comprising lithium iron phosphate (LFP) in an positive electrode.

17. The method of claim 12, wherein the first SOC is a first lower state of charge (SOC) that is less than a critical SOC value, and
the second SOC is a second lower SOC that is less than the critical SOC value and is different from the first lower SOC.

18. The method of claim 17, wherein the first lower SOC represents an SOC of the battery cell at a time point at which discharging of the battery cell is completed, and
the second lower SOC represents an SOC at which an absolute value of a value obtained by differentiating the temperature related to the battery cell with respect to the SOC within a specified lower SOC range becomes a minimum value.

19. The method of claim 18, wherein the lower SOC range comprises an SOC value at which the battery cell is identified as being in a fully discharged state.

20. The method of claim 12, wherein the first SOC is a first upper state of charge (SOC) that is equal to or higher than a critical SOC value, and
the second SOC is a second lower SOC that is equal to or higher than the critical SOC value and is different from the first upper SOC.

21. The method of claim 20, wherein the first upper SOC represents an OSC of the battery cell at a time point at which discharging of the battery cell starts, and
the second upper SOC represents an SOC at which the temperature related to the battery cell within a specified upper SOC range becomes a maximum value.

22. The method of claim 21, wherein the upper SOC range comprises an SOC value at which the battery cell is identified as being in a fully charged state.
